Europäisches Patentamt

European Patent Office

Office européen des brevets

(11) Publication number: **0 415 571 A2**

# EUROPEAN PATENT APPLICATION

(21) Application number: 90308515.7

(51) Int. Cl.5: **H01C 1/01**, H01C 7/00

(22) Date of filing: 02.08.90

(30) Priority: 07.08.89 US 390047

(43) Date of publication of application:
06.03.91 Bulletin 91/10

(84) Designated Contracting States:
DE FR GB

(71) Applicant: FORD MOTOR COMPANY LIMITED
Eagle Way
Brentwood Essex CM13 3BW(GB)
(84) GB

Applicant: FORD-WERKE
AKTIENGESELLSCHAFT
Werk Köln-Niehl Henry-Ford-Strasse
Postfach 60 40 02
W-5000 Köln 60(DE)
(84) DE

Applicant: FORD FRANCE S. A.
B.P. 307
F-92506 Rueil-Malmaison Cédex(FR)
(84) FR

(72) Inventor: Baker, Jay D.
P.O. Box No. 404
Lansdale, Pennsylvania 19446(US)
Inventor: Trublowski, John
3949 Highland Drive
Troy, Michigan 48083(US)
Inventor: Zitzmann, Alice D.
3603 W.Bradford Drive
Brimingham, Michigan 48010(US)

(74) Representative: Messulam, Alec Moses et al
A. Messulam & Co. 24 Broadway
Leigh on Sea Essex SS9 1BN(GB)

(54) Layered thick film resistors and method for producing same.

(57) Layered thick film resistors are formed by printing unitary resistor elements (18) coextensively with dielectric platforms (14) formed on a ceramic substrate (12). The use of a dielectric platform (14) improves resistor geometry by raising the level of the printing surface above the nearby conductor lines and dielectric lines. The dielectric platform (14) can be formed by various processes such as a thick film printing process, a green tape cofire process, or moulding of the dielectric platform into the unfired ceramic substrate.

*FIG-1*

# LAYERED THICK FILM RESISTORS AND METHOD FOR PRODUCING SAME

The present invention relates to an improved thick film resistor and a method for producing the same and, more particularly, it relates to a layered thick film resistor having dielectric platforms for the resistor elements and to a method for forming the layered thick film resistor.

Presently, electronic circuit products are typically made using a ceramic circuit board. As pointed out in Taguchi et al U.S. Patent No. 4,464,20, the processes for manufacturing ceramic circuit boards can be roughly classified into two types, viz: a green sheet process and a thick film process. The thick film process starts with a sintered ceramic plate as the substrate. Common is a fired alumina substrate. A conductor paste is screen printed onto the alumina substrate and fired to form conductor lines. Thereafter a pattern of electrical resistance material is screen printed onto the substrate and fired to form resistor elements which are connected up to the conductor lines.

Various types of screening equipment are capable of producing such thick film resistors. See, for example, De Hart et al U.S. Patent No. 3,464,351. De Hart describes a circuit screening machine wherein resistive paste (thick film printing ink) contained within the pressurised piston of a cylinder is supplied to a squeegee. The squeegee then wipes the paste onto a screen, the paste passing through the open pattern of the screen and being deposited on the substrate.

On complex circuits, fired conductor and dielectric lines in the vicinity of the resistor element to be printed causes the screen printer's squeege to be raised slightly above the screen printing surface. This results in a printed thick film resistor with geometric and thickness non-uniformities. As a result resistance values from substrate to substrate will vary depending on these variances in geometric and thickness tolerances.

In an attempt to overcome such variances, and otherwise improve upon the hand operated, one-at-a-time circuit screening machine of De Hart, Bloom et al in U.S. Patent No. 4,338,351 suggests an apparatus and process for producing thick film resistors having more uniform resistance characterics. Bloom et al utilises a continuous closed-loop feedback network. That network detects deviations from standard resistivity values and continuously corrects the composition by varying the proportions of high and low resistance material ratios or blends of such materials being screened onto the substrates. It also detects deviations in screened-on film thickness for continuously correcting either the speed of operation of a screener assembly or the squeegee head pressure in order to obtain a more uniform film thickness. While such an apparatus and process may result in more uniform resistance characteristics, it is complicated indeed. The need clearly remains for a less complicated and more efficient system to obtain dimensional and geometric control of the printed resistor elements.

It is also known to use a dielectric layer in the making of a thick film resistor device. Thus, Antes et al in U.S. Patent No. 3,998,980 discloses producing a thermal printhead by depositing a dielectric layer on an alumina substrate and then conductors and thick film resistor layers are deposited upon the dielectric layer in an overlapping relationship are fired, lapped, and annealed. The function of the dielectric platform is stated as being twofold-first, to act as a thermal buffer for the resistor element and, second, to raise the level of the resistor material above the substrate so that it may be in closer contact to the thermal record material. Antes et al does not disclose that dimensional and geometrical control can be achieved by use of a dielectric platform and, in fact, the overlapping arrangement of Antes et al prevents Antes et al from fully obtaining such dimensional and geometrical control.

Accordingly, the need remains for a simple and efficient means of obtaining dimensional and geometrical control of the printed resistor elements in a thick film resistor and thereby obtain more uniform resistance characteristics.

According to the present invention there is provided a layered thick film resistor, comprising, a substrate a dielectric platform formed on said substrate, said dielectric platform having an upper surface elevated above the surface of said substrate, a unitary resistor element on the upper surface of said dielectric platform and coextensive therewith, and conductor lines on said substrate and between a portion of said unitary resistor element and a portion of the upper surface of said dielectric platform.

Further according to the invention there is provided a method for producing a layered thick film resistor comprising,

a) providing a substrate,

b) forming a dielectric platform on said substrate so as to provide an upper surface of said dielectric platform elevated above the surface of said substrate,

c) printing conductor lines on said substrate and a portion of the upper surface of said dielectric platform, and

d) printing a unitary resistor element coextensively with the upper surface of said dielectric platform and over the conductor lines thereon

Preferably, the layered thick film resistor has a ceramic substrate, such as a fired alumina substrate. But, rather than having conductor lines and resistor elements printed directly onto that substrate, one or more dielectric platforms may be first formed.

Each dielectric platform (reference hereinafter to "the dielectric platform" is not meant to imply that only one dielectric platform is present on the substrate; although, in some instances there may be only one) is formed to a preferred thickness of approximately 10 to 40 microns. As such, the upper surface of the dielectric platform is elevated sufficiently above the surface of the substrate to improve resistor geometry. In addition a dielectric platform of this thickness will fill in and smooth over the substrate non-uniformities. Thus, the substrate surface is typically very rough on a microscopic scale. This roughness contributes to variation in the resistance since the thickness is constantly varying. The dielectric material used for the platform smoothes the surface under the resistor by filling in the microscopic surface imperfections. A well controlled thickness is deposited. This is especially important if the application for the platform is with a direct write systems (i.e. diamond stylus will track the platformed surface with less variation than it will a rough substrate surface).

The dielectric platform may be formed by various methods. Preferably, it is screen printed onto the ceramic substrate using a thick film dielectric ink and known thick film screening techniques. It may also be printed by a direct write system which uses a slot or nozzle which follows a diamond stylus. Alternatively, it may be formed by laminating a dielectric green tape onto the ceramic substrate, such as by using a low temperature green tape cofire process. It is also possible to form the dielectric platform by moulding a platform into a substrate, such as by applying a green tape or building up a platform area in an unfired ceramic substrate prior to firing.

After the dielectric platform is formed on the ceramic substrate, the conductor lines and resistor element are formed. Again, preferably this is by a thick film printing process or a direct write system. Thus, conductor lines approximately 10 to 13 microns thick are printed on the ceramic substrate and on a portion of the upper surface of the dielectric platform. It is desirable that conductor lines not be formed below the platform surface if they were printed beneath the dielectric platform, resistor thickness non-uniformities would reappear. Conductive resistor termination should be formed on the upper surface of the dielectric platform.

The arrangement of the resistor element is also critical. Each dielectric platform should have an approximately 14-18 microns thick unitary resistor element (i.e., not a layered one) coextensive with the upper surface of the dielectric platform (i.e., not overlapping or otherwise extending beyond the periphery of the upper surface of the dielectric platform). Only in this manner is it possible to obtain the improved dimensional and geometrical control of the present invention. In addition a unitary, coextensive resistor element further reduces variability in that post treatment of the resistive material (i.e., trimming) is minimised.

By examining the equation for sheet resistance:

$R = r\,L/A$ where $r$ = sheet resistivity (a material property constant), $L$ = resistor length, $A$ = resistor cross-sectional area (a product of the resistor width and its thickness), one can see that aside from the sheet resistivity, all factors determining the resistor value are controlled by geometry. This means that small reductions in dimensional variability lead to significant improvements in resistance variation. In turn, the circuitry is more precise, processing time is reduced and reliability improved. The present invention takes advantage of these facts to provide an improved thick film resistor.

The invention will now be described further, by way of example, with reference to the accompanying drawings, in which :

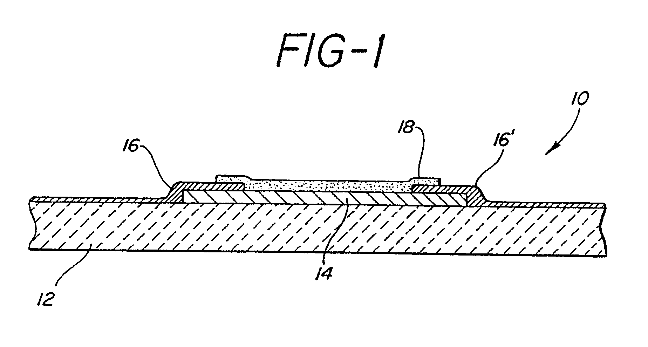

Figure 1 is a schematic cross-section view of the layered thick film resistor of the present invention.

Referring to the Figure, there is shown a portion of a layered thick film resistor 10 made in accordance with the present invention. As can be seen, substrate 12 is shown broken-away, indicating that in the preferred embodiment multiple resistor elements will be present even though only one is shown in Fig. 1. As, shown, substrate 12 has formed thereon dielectric platform 14. Conductor lines 16, 16′ are formed on substrate 12 and a portion of the upper surface of dielectric platform 14. Resistor element 18 is formed on the upper surface of dielectric platform 14 and over the portion of conductor lines 16, 16′ which are on the upper surface of dielectric platform 14.

Preferably substrate 12 is a ceramic substrate such as a fired alumina substrate; although, other substrate materials such as SiN, AlN, Quartz, porcelain on steel, and polymeric substrates may be used.

As mentioned dielectric platform 14 can be formed on substrate 12 by a number of processes. In the most preferred process a thick film dielectric paste such as DuPont 5704 dielectric from E.I. duPont deNemours, Wilmington, Delaware, is screen printed (in one or more passes) onto a ceramic substrate to a thickness of approximately 10 to 40 microns. The assembly may then be fired using a 60 minute cycle with a peak temperature of 850°C for 10 minutes or a 30 minute cycle again with a peak temperature of 850°C for 10 minutes. When a polymeric substrate is used, the thick film dielectric paste is preferably a polymeric material such a P7130 from EMCA/Rohm and Hass of Montgomeryville, PA. Accordingly to EMCA P7130 is compatible with all rigid and semi-rigid substrates and all EMCA polymer conductors and resistors. P7130 cures in an oven about 3.5 minutes at 175°C in an infrared conveyor furnace or in about 35 minutes at 165°C in a circulating air convection type oven. As an alternative embodiment, dielectric platform 14 may be formed by laminating a low temperature green tape, or several layers of green tape, amounting to a thickness of approximately 10 to 40 microns. As still a further alternative embodiment, dielectric platform 14 may be formed by moulding an approximately 10 to 40 microns thickness platform area into an unfired alumina substrate and then firing to sinter the alumina substrate. Combinations of these processes may also be used to build up a dielectric platform to the desired thickness.

In any event, after dielectric platform 14 is formed on substrate 12, preferably conductor lines 16, 16' are screen printed onto substrate 12 and onto a portion of the upper surface of dielectric platform 14. The material for conductor lines 16, 16' is not critical and when a ceramic substrate is used may be selected from any one of the alloy families of gold, silver, palladium silvers, platinum gold or palladium golds such as are typically used by the thick film circuit industry. An alloy-containing thick film conductor paste such as DuPont 9476 conductor paste from E.I. duPont deNemours, Wilmington, Delaware, may be used with ceramic substrates such as a fired alumina substrate. DuPont composition 9476 is a platinum/palladium/silver conductor paste which may be fired through a belt furnace using a 60 minute cycle with 5-10 minutes at a peak of 850°C. Actually, peak temperatures may be varied between 760°C and 950°C with such a conductor material. When a polymeric substrate is used, the conductor material may be a polymer silver such as P2422 from EMCA/Rohm and Haas of Montgomeryville, PA. P2422 cures in about 30 minutes at 165°C in a convection oven and in about 5-7 minutes at 165°C in an infrared oven. The resulting conductor lines 16, 16' may be approximately 10 to 13 microns thick.

Resistor element 18 is formed next using screen printing techniques. When a ceramic substrate is used the material used in constructing the resistor element may be a resistor paste containing Ru, Pd, Carbon, Tantalum Nitride such as any one of as the DuPont Birox 1900 series resistor pastes available from E.I. duPont deNemours, of Wilmington, Delaware. Birox 1900 resistor material may be fired on a 30 minute firing cycle with 10 minutes at a peak temperature of 850°C. When a polymeric substrate is used the resistor material may be a polymer resistor ink such as P3900 from EMCA/Rohm and Haas of Montgomeryville, PA. P3900 cures in about 6 minutes at 210°C in an infrared oven and in about 15-20 minutes at 210-220°C in a convection oven. In either event the resulting resistor element will be approximately 14-18 microns thick.

The following examples are illustrative:

## Example I

The test substrate selected for the study of this Example was the Ford Four Wheel Anti-Lock Braking (4WAL) prototype design. This was chosen since it is a large substrate densely printed with resistors located in all areas of the printing surface. Four samples were randomly selected from a population of 200 parts with resistor elements printed on dielectric platforms and compared to four samples wth resistor elements printed directly on the ceramic substrate. Five thick film resistors with various orientations and locations were measured for length and width differences and their areas calculated and averaged for the four substrates. These were then compared to the nominal, desired values.

The results are shown in Table I below:

Table I

| Nominal | | No Dielectric Platform | | | Dielectric Platform | |
|---|---|---|---|---|---|---|
| Resistor # | Area | Area | % Deviation From Nominal | Area | % Deviation From Nominal | |
| 35 | 4200 | 5377 | 28.0 | 4394 | 4.6 | |
| 6 | 3500 | 3789 | 8.3 | 3768 | 7.7 | |
| 59 | 7000 | 7443 | 6.3 | 7406 | 5.8 | |
| 74 | 4800 | 5680 | 18.3 | 5002 | 4.2 | |
| 101 | 6300 | 6833 | 8.5 | 6680 | 6.0 | |
| Average Standard Deviation 3.167 0.5646 Note: Dimensions are in square mils. | | | | | | |
| Average Thickness (20 samples) | | | | | | |
| Nominal: 12 micron No Dielectric Platform: 14.82 micron (+23.5% deviation from nominal) (standard deviation: 2.73 micron) Dielectric Platform: 12.45 micron (+3.75% deviation from nominal) (standard deviation: 2.32 micron) | | | | | | |

The area difference from nominal for the thick film resistors with no dielectric platforms ranged from +6.3% to +28% while the thick film resistors with dielectric platforms varied from +4.2% to +7.7%. Of significant interest is also the comparison between the average standard deviation of the area measurements for the two techniques, 3.167 sq. mils for the thick film resistors having resistor elements printed directly on ceramic substrates and 0.565 sq. mils for those having resistor elements printed on dielectric platforms.

Thickness measurements on these pairs of samples indicated that on the average, the thick film resistors having dielectric platforms were printed closer to the desired nominal value with a slightly smaller standard deviation. A visual examination of the thickness profile reveals that the non-uniformities typically observed along the edges of the printed resistor element have been significantly reduced or eliminated in the resistor element printed on the dielectric platform.

A comparison was also made of thick film resistors having resistor elements printed on both bare ceramic substrates and those printed on dielectric platforms. Visually one can see significant differences between the two processes. The geometry of the thick film resistors having resistor elements printed on dielectric platforms appears uniform while those having resistor elements printed in the same areas on the plain ceramic substrate have disfigured edges.

Example II

Because the thermal path is increased with a thickness of dielectric platform below the resistor element, there is some concern as to the ability of certain low ohmic value resistors to dissipate heat generated under high voltage transient (load dump) conditions. An experiment was devised to first compare the behaviour of thick film resistors having resistor elements printed on dielectric platforms with those having resistor elements printed on bare ceramic substrates and secondly to arrive at a design rule for sizing of resistor elements printed on dielectric platforms which may be exposed to load dump.

The test was modelled after the TFI circuit currently in production at Ford Motor Company. R 12 on this product is a 55 ohm resistor which under certain conditions may be exposed to high voltage transient electrical stress. The resistor is printed with DuPont 1600 or 6200 series resistor paste and is sized to dissipate 50 W/sq.in. In addition an 18 V zener diode protects this portion of the circuit. As a baseline, untrimmed samples were pulled out of current production, laser trimmed, epoxied to a baseplate and subjected to the load dump test (Ford Spec. # ES-E3EF-12A297-AA Rev. C, Room Temperature). These thick film resistors are ones having resistor elements printed on bare alumina substrate, trimmed using an L-cut, and they currently pass this test. All of the samples tested also passed this test.

Next, a test substrate containing only R 12, the diode and baseplate was fabricated. The resistor size was varied from 50 W/sq.in. to 25 W/sq.in. in increments of 10 W/sq.in. All resistor elements were printed using blended DuPont 1900 series resistor paste on top of either one or two layers of fired DuPont 5704 dielectric platforms and trimmed to 55 ohms. The trim depth for these parts was about 50% into the dielectric platform. Samples were measured for resistance drift and SEM photographs of the trim terminations were taken both before and after being exposed to load dump.

The results are shown in Table 2 below:

Table 2

| Resistor Description | Size (W/sq.in.) | R (before) (Ohm) | R (after) (Ohm) | Change (Ohm) | # Open |
|---|---|---|---|---|---|
| 1600 paste | 50 | 54.56 | 54.55 | -0.01 | 0 |
| 1600 paste | 50 | 54.77 | 54.87 | +0.10 | 2** |
| 1900 paste, untrm | | | | | |
| 1 Layer diel. | 50 | 53.61 | 53.59 | -0.02 | 0 |
| 2 Layer diel. | 50 | 55.10 | 55.16 | +0.06 | 0 |
| 1900 paste, blended to 80 Ohm/sq. | | | | | |
| 1 Layer diel. | 50 | 55.02 | 56.57 | +1.55 | 0 |
| 2 Layer diel. | 50 | 55.06 | 58.43 | +3.37 | 3 |
| 1900 paste, blended to 80 Ohm/sq. | | | | | |
| 1 Layer diel. | 40 | 55.11 | 56.33 | +1.22 | 0 |
| 2 Layer diel. | 40 | 55.16 | 57.80 | +2.64 | 1 |
| 1900 paste, blended to 80 Ohm/sq. | | | | | |
| 1 Layer diel. | 25 | 55.13 | 55.18 | +0.05 | 0 |
| 2 Layer diel. | 25 | 55.09 | 55.16 | +0.07 | 0 |

**The failures seen here were caused by 1) a failed diode and 2) accidental reverse biasing of the sample.

Note: Each data point represents an average of 55 samples.

Note that the change in value for resistors approach the control group when sized at 25 W/sq.in. for both the single and double layer dielectric platforms. A visual inspection showed trim terminations with the typical failure mode, microcracking initiating at the laser trim .termination and propogating across the resistor.

Example III

Another area of investigation for the layered thick film resistors of the present invention involved an evaluation of their heat age stability. The experiment was performed as follows: Dupont 1900 series resistor paste (1K, 10K, and 100K Ohm values) was printed on dielectric platforms formed from single and double layers of DuPont 5704 dielectric. Resistor sizes of 0.080″ x 0.060″ and 0.080″ x 0.080″ were a) left untrimmed b) trimmed to twice their value using an L-cut and c) cut using a single plunge 50% of the resistor width. Ten samples of each were then heat aged for 1000 hours at 150 C. A control group of 6 boards was stored in nitrogen and not heat aged.

The results are shown in Table 3 below:

Table 3

| Heat Age Testing | | | | |
|---|---|---|---|---|
| Percent Resistance Increase After 1000 Hr., 150 C Heat Age | | | | |
| Sample Description | Plunge 50% | L-Cut 2x | No Trim | Control |
| 1K, 1 Layer | 0.0855 | 0.095 | 0.080 | 0.0318 |
| 1K, 2 Layer | 0.0915 | 0.093 | 0.083 | 0.0434 |
| 10K, 1 Layer | 0.230 | 0.209 | 0.220 | 0.0420 |
| 10K, 2 Layer | 0.238 | 1.088 | 0.230 | 0.0284 |
| 100K, 1 Layer | 0.245 | 0.727 | 0.250 | 0.0727 |
| 100K, 2 Layer | 0.245 | 0.240 | 0.240 | 0.0468 |
| Average Change | 0.1802 | 0.4367 | 0.1840 | 0.0442 |

Note: All changes are in pecent of original value and are in the positive direction. All data tabulated at 95% confidence level.

As can be seen, all of the resistor groups had a slight increase in resistance after heat ageing with the 10 K Ohm, 2 layer group showing the largest average increase of 1.088%. Overall, the single plunge samples exhibited an average change of +0.18% while the resistors trimmed to twice their original value had an average difference of +0.44%. The untrimmed resistors behaved similar to the plunge cut group with an increase of 0.18%. An increase in the control group of 0.08% was observed and is probably due to equipment measurement error.

The results of Examples I-III above lead to the following conclusions:

1) Dimensional and thickness uniformity of thick film resistors having resistor elements printed on dielectric platforms in the near vicinity of crossovers is significantly improved when compared to similar thick film resistors having resistor elements printed on bare ceramic substrates.

2) Thick film resistors fabricated with low ohmic value resistor pastes which may be exposed to high voltage electrical stress conditions (such as those seen in load dump situations) should be sized at 25 W/sq.in. if performance similar to 50 W/sq.in. thick film resistors having resistor elements printed on bare alumina substrate is desired. Thick film resistors having resistor elements printed on dielectric platforms from from two layers of dielectric tend to drift more and have more catastrophic failures than those printed on single dielectric layers. Catastrophic failures (defined as those resistors which have changed in value by amounts greater than five percent or have actually caused an open circuit) were observed during the load dump testing. The typical failure mode in these cases is severe microcracking initiating at the laser trim termination and propagating through the resistor.

3) All resistors subjected to 1000 hr. 150 C heat age drifted slightly in the direction of resistance increase. The drift ranged from +0.08% for the 1K Ohm, single layer sample to 1.088% for the 10K Ohm, double layer group. Resistors trimmed to twice their original value drifted more than those trimmed 50% into the resistor with a single plunge. In most cases here was no difference in drift for resistors printed on dielectric platforms found from either single or double layers of dielectric in the dielectric platform.

## Claims

1. A layered thick film resistor, comprising, a substrate (12), a dielectric platform (14) formed on said substrate, said dielectric platform (14) having an upper surface elevated above the surface of said substrate, a unitary resistor element (18) on the upper surface of said dielectric platform (14) and coextensive therewith, and conductor lines (16,16') on said substrate (12) and between a portion of said unitary resistor element (18) and a portion of the upper surface of said dielectric platform (14).

2. A resistor as claimed in claim 1, wherein said substrate is a ceramic substrate.

3. A resistor as claimed in claim 2, wherein said ceramic substrate is a fired alumina substrate.

4. A resistor as claimed in claim 2, wherein said dielectric platform is moulded into said ceramic substrate.

5. A resistor as claimed in any one of the preceding claims, wherein said dielectric platform is formed from a thick film dielectric paste printed onto said substrate, or dielectric green tape laminated onto said substrate.

6. A resistor as claimed in any one of the preceding claims, wherein said dielectric platform is approximately 10 to 40 microns thick.

7. A resistor as claimed in claim 6, wherein said unitary resistor element is approximately 14 to 18 microns thick.

8. A resistor as claimed in claim 7, wherein said thick film resistor is formed by screen printing a thick film resistor paste directly onto said dielectric platform and over said conductor lines.

9. A method for producing a layered thick film resistor comprising,

    a) providing a substrate,

    b) forming a dielectric platform on said substrate so as to provide an upper surface of said dielectric platform elevated above the surface of said substrate,

    c) printing conductor lines on said substrate and a portion of the upper surface of said dielectric platform, and

    d) printing a unitary resistor element coextensively with the upper surface of said dielectric platform and over the conductor lines thereon

10. A method as claimed in claim 9, wherein said substrate is a ceramic substrate.

11. A method as claimed in claim 10, wherein said ceramic substrate is a fired alumina substrate.

12. A method as claimed in claim 10, wherein said dielectric platform is formed by printing a thick film dielectric paste on said ceramic substrate, by laminating a dielectric green tape to said ceramic substrate, or by moulding said dielectric platform into said ceramic substrate prior to firing.

13. A method as claimed in claim 10, wherein said dielectric platform, said conductor line and said unitary resistor element are formed by screen printing.

# FIG-1